# EUROPEAN PATENT SPECIFICATION

(11) **EP 3 336 891 B1**
(45) Date of publication and mention of the grant of the patent: **21.09.2022**
(21) Application number: 17196674.0
(22) Date of filing: 16.10.2017
(51) Int. Cl.: H01L 23/42, H01L 23/433, H01L 23/40

(54) **PRESSURE LIMITING HEAT SINK**
DRUCKBEGRENZUNGSWÄRMESENKE
DISSIPATEUR DE CHALEUR DE LIMITATION DE PRESSION

(30) Priority: 16.12.2016 US 201615381149
(43) Date of publication of application: 20.06.2018
(73) Proprietor: Hamilton Sundstrand Corporation, Charlotte, NC 28217-4578 (US)
(72) Inventor: TROTMAN, Kenneth J., Granby, CT 06035 (US); DUFFY, Jason C., Granby, CT 06060 (US)
(74) Representative: Dehns

(56) References cited:
- EP-A2- 2 428 990
- JP-A- 2000 196 269
- JP-A- 2007 329 338
- US-A1- 2011 075 375
- US-B1- 6 223 815

## Description

This invention was made with government support with the United States Air Force under Contract No. N00014-09-D-0821-M802. The government therefore has certain rights in this invention.

### BACKGROUND

The subject matter disclosed herein relates to heat sinks, and more particularly, to pressure limiting heat sinks.

Electrical components can be utilized within an aircraft and other locations to perform numerous functions. Heat sinks and thermal conductive pads are utilized with electrical components to dissipate heat away from the electrical components. Often, heat sinks may apply excessive pressure to electrical components which may damage the electrical components. JP 2007329338A describes a heat dissipation structure. US 2011/075375 A1 describes a tuner module. EP 2428990 A2 describes an electrical component assembly for thermal transfer. US 6,223,815 B1 describes a cooling unit for a heat-generating component.

### BRIEF SUMMARY

A heat sink for use with a thermal pad is defined in claim 1.

A method to assemble a heat sink assembly for use with a circuit card component is defined in claim 4.

A heat sink assembly for use with a circuit card component, includes a circuit card component, a thermal pad, a heat sink including a heat sink body to engage the thermal pad, and a plurality of relief holes formed within the heat sink body, wherein the plurality of relief holes receives a portion of the thermal pad to limit an applied heat sink pressure onto the component.

Technical function of the embodiments described above includes a plurality of relief holes formed within the heat sink body, wherein the plurality of relief holes receives a portion of the thermal pad to limit an applied heat sink pressure onto the component.

Other aspects, features, and techniques of the embodiments will become more apparent from the following description taken in conjunction with the drawings.

### BRIEF DESCRIPTION OF THE DRAWINGS

The subject matter is particularly pointed out and distinctly claimed in the claims at the conclusion of the specification. The foregoing and other features, and advantages of the embodiments are apparent from the following detailed description taken in conjunction with the accompanying drawings in which like elements are numbered alike in the FIGURES:
FIG. 1A is an elevation view of an embodiment of a heat sink assembly;
FIG. 1B is an exploded assembly view of the heat sink assembly of FIG. 1A; and
FIG. 2 is an isometric view of an embodiment of the heat sink for use with the heat sink assembly of FIG. 1A and 1B.

### DETAILED DESCRIPTION

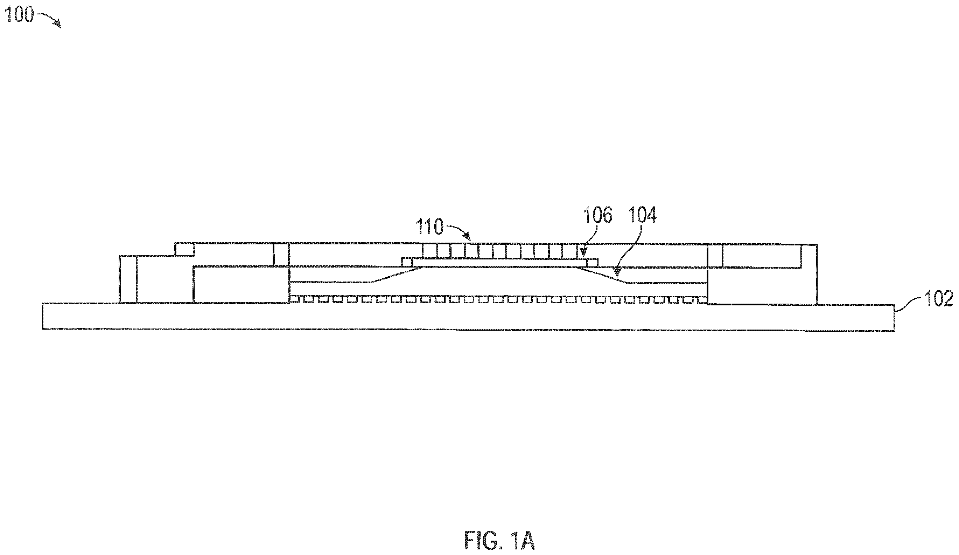

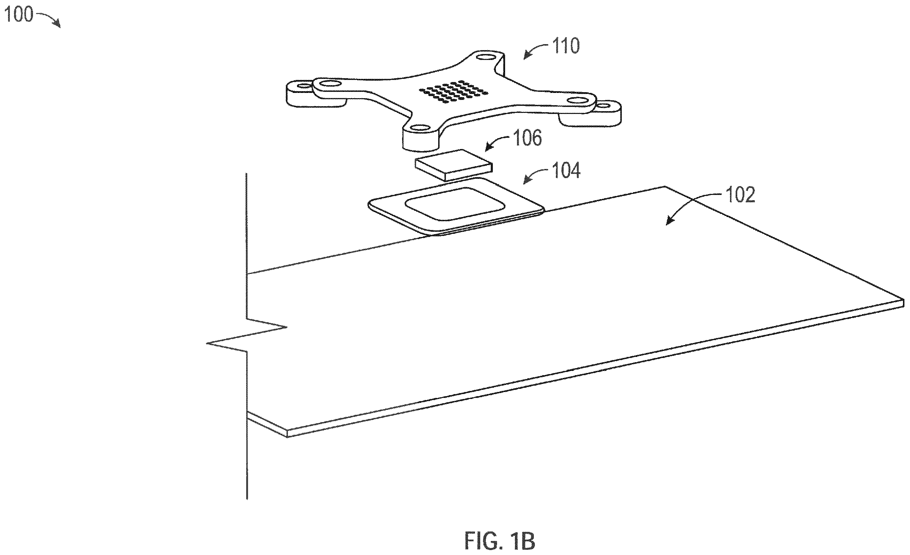

Referring to the drawings, FIG. 1A and 1B show a heat sink assembly 100. In the illustrated embodiment, the heat sink assembly 100 includes a compliant thermal pad 106 and a heat sink 110. In the illustrated embodiment, the heat sink assembly 100 can be used in conjunction with a circuit card assembly 102 and an electrical component 104. In the illustrated embodiment, the heat sink assembly 100 can remove heat from the electrical component 104 to allow for operation and extended reliability. Advantageously, the use of the heat sink 110 allows for sufficient pressure to be applied to the compliant thermal pad 106 to eliminate air gaps and facilitate optimal heat transfer between the electrical component 104 and the heat sink 110 without applying excessive force or pressure to the electrical component 104.

In the illustrated embodiment, the electrical component 104 and the heat sink 110 are mounted to the circuit card assembly 102. Electrical components 104 can be connected or mounted to the circuit card assembly 102 in any suitable manner to facilitate electrical connections and structural mounting. The heat sink 110 can be mounted or otherwise connected to the circuit card assembly 102 via any suitable manner. In the illustrated embodiment, the circuit card assembly 102 is suitable for use in aircraft applications or any other suitable application. In certain applications, such as aircraft applications, the circuit card assembly 102 can be optimized for size, weight, and performance while managing thermal and structural parameters. In certain embodiments, the circuit card assembly 102 can allow for a modular construction of components within an aircraft.

In the illustrated embodiment, the electrical component 104 is a heat generating component. In certain embodiments, the electrical component 104 is a processor. The electrical component 104 can generate significant heat during operation. To allow for proper and continued operation the heat sink 110 can be utilized to transfer heat away from the electrical component 104.

In the illustrated embodiment, the compliant thermal pad 106 is disposed between the electrical component 104 and the heat sink 110. The compliant thermal pad 106 can be utilized to facilitate heat transfer between the electrical component 104 and the heat sink 110 by filling in air gaps between the electrical component 104 and the heat sink 110.

The compliant thermal pad 106 is formed from a material that can be urged into gaps and crevices while allowing for high levels of heat transfer. In certain embodiments, the compliant thermal pad 106 is a preformed pad formed from materials including, but not limited to, paraffin wax, silicone based materials, etc. In certain applications, the compliant thermal pad 106 requires sufficient pressure to allow for desired contact to the electrical component 104 and the heat sink 110. If sufficient pressure is not applied to the compliant thermal pad 106, then the compliant thermal pad 106 may not fully be in contact with the surfaces of the electrical component 104 and the heat sink 110, reducing heat transfer efficiency. Further, by compressing the compliant thermal pad 106, heat transfer across the compliant thermal pad 106 is increased. However, if excess pressure is applied to the compliant thermal pad 106, the electrical component 104 may be damaged.

During assembly, surface variations and gap variability of the electrical component 104 and the heat sink 110 affect the amount of pressure applied to the compliant thermal pad 106 and the electrical component 104. Due to this variability, insufficient pressure may be applied to the compliant thermal pad 106, reducing heat transfer between the electrical component 104 and the heat sink 110. In certain applications, excessive pressure is applied to the compliant thermal pad 106, potentially damaging the electrical component 104 and the heat sink 110.

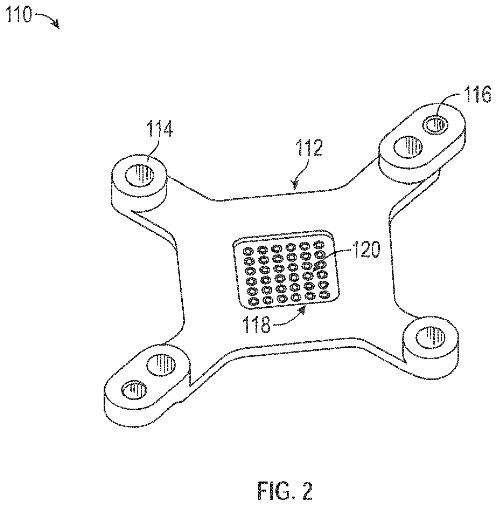

Referring to FIG. 2, an example of a heat sink 110 is shown. In the illustrated embodiment, the heat sink 110 includes a heat sink body 112, mounting holes 114, alignment holes 116, a thermal pad alignment feature 118, and relief holes 120. In the illustrated embodiment, the relief holes 120 of the heat sink 110 can allow for the compliant thermal pad 106 to flow through the relief holes 120 to limit the pressure applied to the compliant thermal pad 106 and the electrical component 104. Advantageously, the heat sink 110 can apply sufficient pressure to the compliant thermal pad 106 to allow for optimal heat transfer without applying excess pressure that may damage the electrical component 104.

In the illustrated embodiment, the heat sink body 112 is formed from metals or any other heat conductive material. In certain embodiments, the heat sink body 112 is formed as a top hat style heat sink that is disposed on top of the electrical component 104. In the illustrated embodiment, the heat sink body 112 is formed to transfer heat from the electrical component 104 to the environment. The heat sink body 112 includes features to increase the surface area available for cooling.

In the illustrated embodiment, the heat sink body 112 includes mounting holes 114 formed therethrough. The mounting holes 114 can allow fasteners to pass through and affix the heat sink 110 to the circuit card assembly 102. In certain embodiments, as the heat sink body 112 is affixed to the circuit card assembly 102, the compliant thermal pad 106 is compressed between the electrical component 104 and the heat sink 110. As previously discussed, due to the gap variability between the surfaces of the electrical component 104 and the heat sink 110, the amount of force applied to the electrical component 104 and the compliant thermal pad 106 can vary.

In certain embodiments, the heat sink body 112 includes alignment holes 116 to align the heat sink 110 during assembly. The alignment holes 116 can receive alignment pins that are disposed in the circuit card assembly or otherwise provide a guide for locating the heat sink 110 during assembly.

In the illustrated embodiment, the heat sink body 112 includes a thermal pad alignment feature 118. In the illustrated embodiment, the thermal pad alignment feature 118 is a recessed portion of the heat sink body 112 that is configured to receive the compliant thermal pad 106 during assembly. The thermal pad alignment feature 118 can provide visual and tactile feedback regarding the alignment of the compliant thermal pad 106 and the electrical component 104 disposed below the heat sink 110 during assembly. Advantageously, the thermal pad alignment feature 118 can allow for faster assembly and prevent damage to the electrical component 104.

In the illustrated embodiment, the heat sink 110 includes relief holes 120. The relief holes 120 allow for portions of the compliant thermal pad 106 to flow from between the electrical component 104 and the heat sink 110 to reduce the volume of the compliant thermal pad 106 material being compressed to limit the pressure experienced by the electrical component 104 and the compliant thermal pad 106. Advantageously, the use of the relief holes 120 limits the maximum pressure that can be applied by the heat sink 110 while still allowing for optimal contact and heat transfer between the electrical component 104, the compliant thermal pad 106, and the heat sink 110.

The relief hole 120 parameters are altered to provide a desired pressure limit. The size of the relief holes 120, the quantity of the relief holes 120, and the position of the relief holes 120 are altered to provide a desired pressure limit by controlling the amount of the compliant thermal pad 106 material that can flow through the relief holes 120. Further, in certain embodiments, the type, size, and material of the compliant thermal pad 106 can be modified to provide a desired pressure limit.

The relief holes 120 are aligned to be disposed above the compliant thermal pad 106 when the heat sink assembly 100 is assembled. The relief holes 120 are located within the recessed portion of the thermal pad alignment feature 118.

Advantageously, by allowing the heat sink 110 to apply the desired pressure, the compliant thermal pad 106 can be compressed to fill air gaps between the heat sink 110 and the electrical component 104 and maximize heat transfer between the heat sink 110 and the electrical component 104 by allowing for thinner bond lines therebetween minimizing thermal resistance. Further, the relief holes 120 allow for ease of inspection of proper alignment and installation of the compliant thermal pad 106 and the electrical component 104 disposed beneath the heat sink 110. Further, the relief holes 120 can retain the compliant thermal pad 106 during and after assembly to prevent unwanted movement.

## Claims

1. A heat sink (110) for use with a thermal pad (106), the heat sink (110) comprising:
a heat sink body (112) to engage the thermal pad (106); and wherein said heat sink body (112) engages said thermal pad (106) between said heat sink body (112) and an electrical component;
a plurality of relief holes formed within the heat sink body (112), wherein the plurality of relief holes (120) receives a portion of the thermal pad to limit an applied heat sink pressure onto a component,
the heat sink body (112) includes an alignment feature (118) to receive the thermal pad, wherein the alignment feature (118) is a recessed portion of the heat sink body (112), and wherein said relief holes (120) are configured to allow for the thermal pad (106) to flow through the relief holes (120), and **characterized in that** a size and a quantity and a position of the plurality of relief holes (120) corresponds to the applied heat sink pressure onto the component.

2. The heat sink of claim 1, wherein the heat sink body (112) includes at least one mounting hole (114).

3. The heat sink of any preceding claim, wherein the heat sink body (112) includes at least one alignment hole (116).

4. A method to assemble a heat sink assembly for use with a circuit card component, the method comprising:
disposing a thermal pad (106) on the circuit card component;
engaging the thermal pad (106) between a heat sink body (112) of a heat sink (110) and the circuit card component;
applying a force to the heat sink (110); and
limiting an applied heat sink pressure onto the component by receiving a portion of the thermal pad (106) in a plurality of relief holes (120) formed within the heat sink body (112); and further comprising
receiving the thermal pad (106) via an alignment feature (118) of the heat sink body (112), wherein the alignment feature (118) is a recessed portion of the heat sink body (112), and wherein said relief holes (120) are configured to allow for the thermal pad (106) to flow through the relief holes, and **characterized in that** a size and a quantity and a position of the plurality of relief holes (120) corresponds to the applied heat sink pressure onto the component.

5. The method of any of claim 4, wherein the heat sink body (112) includes at least one mounting hole (114) or at least one alignment hole (116).

## Patentansprüche

1. Wärmesenke (110) zur Verwendung mit einem Wärmeleitpad (106), wobei die Wärmesenke (110) Folgendes umfasst:
einen Wärmesenkenkörper (112) zum Eingreifen mit dem Wärmeleitpad (106); und wobei der Wärmesenkenkörper (112) mit dem Wärmeleitpad (106) zwischen dem Wärmesenkenkörper (112) und einer elektrischen Komponente in Eingriff steht;
eine Vielzahl von Entlastungslöchern, die innerhalb des Wärmesenkenkörpers (112) ausgebildet ist, wobei die Vielzahl von Entlastungslöchern (120) einen Teil des Wärmeleitpads aufnimmt, um einen auf eine Komponente ausgeübten Druck der Wärmesenke zu begrenzen,
wobei der Wärmesenkenkörper (112) ein Ausrichtungsmerkmal (118) zum Aufnehmen des Wärmeleitpads beinhaltet, wobei das Ausrichtungsmerkmal (118) ein vertiefter Abschnitt des Wärmesenkenkörpers (112) ist und wobei die Entlastungslöcher (120) dazu konfiguriert sind, zu ermöglichen, dass das Wärmeleitpad (106) durch die Entlastungslöcher (120) fließt, und **dadurch gekennzeichnet, dass** eine Größe und eine Menge und eine Position der Vielzahl von Entlastungslöchern (120) dem auf die Komponente ausgeübten Druck der Wärmesenke entspricht.

2. Wärmesenke nach Anspruch 1, wobei der Wärmesenkenkörperkörper (112) mindestens ein Montageloch (114) beinhaltet.

3. Wärmesenke nach einem der vorangehenden Ansprüche, wobei der Wärmesenkenkörper (112) mindestens ein Ausrichtungsloch (116) beinhaltet.

4. Verfahren zum Zusammenbauen einer Wärmesenkenbaugruppe zur Verwendung mit einer Leiterplattenkomponente, wobei das Verfahren Folgendes umfasst:
Anordnen eines Wärmeleitpads (106) auf der Leiterplattenkomponente;
Ineingriffbringen des Wärmeleitpads (106) zwischen einem Wärmesenkenkörper (112) einer Wärmesenke (110) und der Leiterplattenkomponente;
Ausüben einer Kraft auf die Wärmesenke (110); und
Begrenzen eines auf die Komponente ausgeübten Drucks der Wärmesenke durch Aufnehmen eines Abschnitts des Wärmeleitpads (106) in einer Vielzahl von Entlastungslöchern (120), die innerhalb des Wärmesenkenkörpers (112) ausgebildet ist; und
ferner umfassend
Aufnehmen des Wärmeleitpads (106) über ein Ausrichtungsmerkmal (118) des Wärmesenkenkörpers (112), wobei das Ausrichtungsmerkmal (118) ein vertiefter Abschnitt des Wärmesenkenkörpers (112) ist und wobei die Entlastungslöcher (120) dazu konfiguriert sind, zu ermöglichen, dass das Wärmeleitpad (106) durch die Entlastungslöcher fließt, und **dadurch gekennzeichnet, dass** eine Größe und eine Menge und eine Position der Vielzahl von Entlastungslöchern (120) dem auf die Komponente ausgeübten Druck der Wärmesenke entspricht.

5. Verfahren nach Anspruch 4, wobei der Wärmesenkenkörper (112) mindestens ein Montageloch (114) oder mindestens ein Ausrichtungsloch (116) beinhaltet.

## Revendications

1. Dissipateur de chaleur (110) destiné à être utilisé avec un tampon thermique (106), le dissipateur de chaleur (110) comprenant :
un corps de dissipateur de chaleur (112) pour venir en prise avec le tampon thermique (106) ; et dans lequel ledit corps de dissipateur de chaleur (112) vient en prise avec ledit tampon thermique (106) entre ledit corps de dissipateur de chaleur (112) et un composant électrique ;
une pluralité d'orifices de détente formés à l'intérieur du corps de dissipateur de chaleur (112), dans lequel la pluralité d'orifices de détente (120) reçoit une partie du tampon thermique pour limiter une pression de dissipateur de chaleur appliquée sur un composant,
le corps de dissipateur de chaleur (112) comporte un élément d'alignement (118) pour recevoir le tampon thermique, dans lequel l'élément d'alignement (118) est une partie évidée du corps de dissipateur de chaleur (112), et dans lequel lesdits orifices de détente (120) sont configurés pour permettre au tampon thermique (106) de s'écouler à travers les orifices de détente (120), et **caractérisé en ce qu'**une taille et une quantité et une position de la pluralité d'orifices de détente (120) correspondent à la pression de dissipateur de chaleur appliquée sur le composant.

2. Dissipateur de chaleur selon la revendication 1, dans lequel le corps de dissipateur de chaleur (112) comporte au moins un orifice de montage (114).

3. Dissipateur de chaleur selon une quelconque revendication précédente, dans lequel le corps de dissipateur de chaleur (112) comporte au moins un orifice d'alignement (116).

4. Procédé d'assemblage d'un ensemble dissipateur de chaleur destiné à être utilisé avec un composant de carte de circuit, le procédé comprenant :
la disposition d'un tampon thermique (106) sur le composant de carte de circuit ;
la mise en prise du tampon thermique (106) entre un corps de dissipateur de chaleur (112) d'un dissipateur de chaleur (110) et le composant de carte de circuit ;
l'application d'une force au dissipateur de chaleur (110) ; et
la limitation d'une pression de dissipateur de chaleur appliquée sur le composant en recevant une partie du tampon thermique (106) dans une pluralité d'orifices de détente (120) formés à l'intérieur du corps de dissipateur de chaleur (112) ; et
comprenant en outre
la réception du tampon thermique (106) via un élément d'alignement (118) du corps de dissipateur de chaleur (112), dans lequel l'élément d'alignement (118) est une partie évidée du corps de dissipateur de chaleur (112), et dans lequel lesdits orifices de détente (120) sont configurés pour permettre au tampon thermique (106) de s'écouler à travers les orifices de détente, et **caractérisé en ce qu'**une taille et une quantité et une position de la pluralité d'orifices de détente (120) correspondent à la pression de dissipateur de chaleur appliquée sur le composant.

5. Procédé selon une quelconque revendication 4, dans lequel le corps de dissipateur de chaleur (112) comporte au moins un orifice de montage (114) ou au moins un orifice d'alignement (116) .
